# EUROPEAN PATENT APPLICATION

(11) **EP 2 995 966 A1**
(43) Date of publication of application: **16.03.2016**
(21) Application number: 14184009.0
(22) Date of filing: 09.09.2014
(51) Int. Cl.: G01R 31/327

(54) **Method and device for online monitoring of high voltage circuit breaker**

(71) Applicant: ABB Technology AG, 8050 Zürich (CH)
(72) Inventor: Madonna, Gian-Luigi, 8112 Otelfingen (CH); Zlatanski, Martin, 5430 Wettingen (CH); Hochlehnert, Moritz, 79771 Klettgau-Griessen (DE); Marinkovic, Stevan, 5430 Wettingen (CH); Maret, Yannick, 5405 Dättwil (CH)
(74) Representative: ABB Patent Attorneys

(57) **Abstract**

The invention relates to a method for measuring a condition of at least one circuit breaker (2) in a high voltage system (1), wherein the at least one circuit breaker (2) having a contact pair (24, 26); comprising the steps of:
- injecting a transient test signal through a first coupling means (53) into a first terminal (21) of each of the at least one circuit breaker (2);
- detecting a resulting transient test signal through a second coupling means (54) at a second terminal (22) of each of the at least one circuit breaker (2);
- detecting, during an operation of the circuit breaker (2), the instant of physical contact of the contacts of the contact pair (24, 26), wherein the instant of contact is detected by a change of the amplitude level and/or phase value and/or noise level of the received test signal, when setting the at least one circuit breaker (2) to close or to open, and
- determining the condition of the at least one circuit breaker (2) depending on a time delay defined by the instant of contact and by a further instant,

wherein the further instant corresponds to an instant of an additional change of the amplitude level and/or phase value and/or noise level of the received test signal during the operation of the at least one circuit breaker (2).

## Description

### Technical field

The present invention relates to circuit breakers for high-voltage applications, in particular to monitor the condition of a high-voltage circuit breaker.

### Background

Circuit breakers are used for switching electrical connections employed for the supply, generation, distribution and transmission of electrical energy.

When opening circuit breakers for interrupting high currents or closing circuit breakers for enabling power transmission, an electrical arc is formed that tends to ablate the contact regions of the circuit breaker. Hence, common high-voltage circuit breakers have a pair of arcing contacts and a pair of main contacts which are respectively closed or opened with a time delay when the circuit breaker is operated.

In a fully closed condition, arcing and main contacts are electrically connected in parallel. While the main contact pair provides very low impedance in closed condition, the arcing contact pair exhibits substantially higher impedance in closed condition but is designed to withstand arcs better than the main contact regions. In an open condition, the arcing contact regions of the arcing contact pair are usually situated closer to each other than the main contact regions of the main contact pair.

Hence, when the circuit breaker is being closed, the arcing contact regions connect to each other first to initially feed the current. If the voltage difference between the contact regions is sufficiently large, a (pre-)arc is generated as the arcing contact regions approach. The main contact regions contact each other after the time delay without any arcing. Conversely, when the circuit breaker is being opened the main contact regions separate before the arcing contact regions so as to restrict any arcs after the time when the arcing contact pair opens.

Due to electrical arc generation in high-voltage/high-current switching operations (in particular openings and possibly closings), the arcing contact regions ablate, which particularly physically degrades the arcing contacts by e.g. reducing their length or hollowing out them. This reduced length leads to a decreased difference between the distances of the arcing contact regions and the main contact regions.

The opening overlap time - defined as the time between opening the main contact and opening the arcing contact - will thus decrease with the lengths of the arcing contact regions. This increases the risk of the formation of an electrical arc between the main contact regions, which would result in damage to or destruction of the circuit breaker.

In order to ensure permanent, reliable operation of the circuit breaker, the ablation level of the arcing contacts is usually tracked by measuring the overlap time, which is the time interval between the connection or disconnection of the arcing contact pair and main contact pair, respectively. Since a mostly constant displacement velocity is applied when opening and closing the circuit breaker contact pairs, the difference in timing between the contacting pairs may be directly related to the ablation contact length. Monitoring the overlap time as a critical parameter provides information on the ablation level of the arcing contact pair.

Document US 6,850,072 B1 discloses an apparatus for analyzing the condition of high-voltage circuit breakers. For analyzing the ablation level of the circuit breaker, each of the circuit breaker contacts is electrically coupled to ground, a test voltage is supplied across the circuit breaker contact, an output voltage signal is measured, the state of the circuit breaker contact pair is changed and a step-change of the output voltage is detected that corresponds to the change of the state of the circuit breaker. Furthermore, the arcing time might be used as an indication of the impact of an operation on the condition of the circuit breaker wherein the arcing time is defined as the time elapsed between the instant the contact regions physically separate and the instant the electrical current ceases to flow.

Moreover, the condition of the circuit breaker can also be degraded by a pre-arc and the pre-arcing time might give an indication of the impact of an operation on the condition of the circuit breaker. Pre-arcing usually occurs during a closing operation due to a potential difference between the contact regions higher than the dielectric strength of the contact gap. Pre-arcing time is defined as the time elapsed between the instant the electrical current starts to flow and the instant the contact regions physically get in touch with each other.

To further derive the exact degradation induced by the (pre-)arcing the interrupted/switched current may be further considered wherein the switched current corresponds to the current change occurring during the operation of the circuit breaker. Particularly, the switched current indicates a current flowing at a fully closed state of the circuit breaker, i.e. the current to be switched. Hence, the pre-arcing/arcing time and the amount of switched/interrupted current indicate the degradation of the breaker for the closing/opening operations. Integrating or summing the degradations respectively allows to track the health of the breaker.

The arcing and pre-arcing time, respectively, of a circuit breaker can be determined by measuring a voltage across the terminals of the circuit breaker or the voltages between the terminals of the circuit breaker and a reference potential wherein the arcing time and the arcing voltage can be determined using the voltage waveforms.

Furthermore, as e.g. disclosed in EP 0 178 733 A2 and EP 0 482 547 B1, the arcing time and pre-arcing time, respectively, can be measured by detecting the amount of light emitted by the arc by means of optical sensors.

Alternatively, the arcing and pre-arcing times can be detected by measuring an electromagnetic emission during the switching operation.

The above methods for determining the condition of the circuit breaker have either a substantially low immunity to noise and interference or cannot be applied online (i.e. during the normal operation of the circuit breaker) or need a clear line of sight to the inside of the breaking chamber (i.e. need to be installed in the breaking chamber or can only be applied to open-type breaking chamber).

It is therefore an object of the present invention to provide a more reliable method for monitoring the condition of a circuit breaker which can be applied during the operation of the circuit breaker.

### Summary of the invention

This object has been achieved by the method for monitoring a condition of a circuit breaker according to claim 1 and by the device and the system according to the further independent claim.

Further embodiments are indicated in the depending subclaims.

According to a first aspect, a method for measuring the condition of at least one circuit breaker in a high voltage system is provided, wherein the at least one circuit breaker having a contact pair; comprising the steps of:
- injecting a transient test signal through a first coupling means into a first terminal of each of the at least one circuit breaker;
- detecting a resulting transient test signal through a second coupling means at a second terminal of each of the at least one circuit breaker;
- detecting, during an operation of the circuit breaker, an instant of physical contact of the contacts of the contact pair wherein the instant of contact is detected by a particularly transient change of the amplitude level and/or phase value and/or noise level of the received test signal, when setting the at least one circuit breaker to close or to open, and
- determining the condition of the at least one circuit breaker depending on a time delay defined by the instant of contact and by a further instant, wherein the further instant corresponds to an instant of an additional change of the amplitude level and/or phase value and/or noise level of the received test signal during the operation of the at least one circuit breaker.

One idea of the above method is to monitor the condition of a circuit breaker depending on a measurement of the time delay of the change in electrical behavior of the circuit breaker during a switching operation. After the contact regions of an energized circuit breaker have been physically disconnected in an opening operation, electrical charge could be transported between the contact regions of one of the contact pairs to the other through an arc. Similarly, during a closing operation, the break-down of the dielectric separation of the two contact regions of the circuit breaker can occur if the potential difference across the contact regions is higher than the dielectric strength of the contact gap.

The time delay may indicate an arcing time during an opening operation of the circuit breaker or a pre-arcing time during a closing operation of the circuit breaker. The arcing and pre-arcing time, respectively, can be measured by monitoring the variations in amplitude and/or phase and/or noise of a test signal injected through a first terminal of the circuit breaker and tapped at a second terminal of the circuit breaker.

According to an embodiment, the instant of contact may be detected by a change of the noise level of the received test signal.

According to an embodiment, the time delay may include an arcing time which is determined during an opening operation of the at least one circuit breaker as the time difference between the instant of the contact separation and the further instant of extinction of an arc which is detected by a change of the amplitude level and/or phase value on the received test signal. The arcing time can indicate the ablation level of the contact pair.

Furthermore, the time delay may include a pre-arcing time which is determined during a closing operation of the at least one circuit breaker as the time difference between the further instant of generation of an arc which is detected by a change of the amplitude level and/or phase value of the received test signal and the instant of contact, as the instant of joining the contact. The pre-arcing time can indicate the ablation level of the contact pair.

During an opening operation, an arc can be incepted. Basically on the occurrence of an arc, the time instant of contact as the point of time at the opening of the contact may be difficult to detect since the arc conducts the test signal. Options to detect the duration of the arc by monitoring the test signal may be as follows:
1. Analysing the noise content of the received test signal since the noise increases at the beginning of the arc period, where the noise level is kept/increased as long as the arc exists.
2. Analysing transient peaks which occur at the instant at or just before the inception of the arc, since the voltage difference across the separated contacts increases abruptly due the inductive nature of the electrical system. A transient peak in the received test signal is thus created at the time instant of this abrupt changes in voltage, which actually corresponds to the opening of the arcing contact.
3. Analysing the strength of the received test signal. The test signal strength may slightly but suddenly decrease at the inception of the arc and may then gradually decrease as long as the arc exists.

According to an embodiment, a remaining lifetime of the at least one circuit breaker may be determined based on the detected condition, e.g. the ablation level, of the contact pair. The determination of the arcing time and pre-arcing time allows one to obtain an indication about the condition of the circuit breaker and to derive the overall remaining lifetime thereof.

It may be provided that the at least one circuit breaker has an arcing contact pair as the contact pair and a main contact pair providing different impedances, wherein the circuit breaker is further configured so that during opening operations the arcing contact pair opens after the main contact pair opens, and during closing operations the arcing contact pair closes before the main contact pair closes, wherein an overlap time is determined during an operation of the at least one circuit breaker based on the time delay between the instant of contact and the further instant which is detected by a change of the amplitude level and/or phase value due to an impedance change.

Moreover, multiple circuit breakers are provided, wherein the first time of closing or opening of the arcing contact pair of each of the circuit breakers and a second time of closing or respectively opening of each of the circuit breakers is communicated to a master unit, wherein the condition of each of the multiple circuit breakers are determined in the master unit.

It may be provided that multiple circuit breakers are provided, wherein at least two of the transient test signals injected into the respective circuit breakers have at least one different frequency.

According to a further aspect system for monitoring a condition of at least one circuit breaker in a high voltage system is provided; comprising:
- for each of the at least one circuit breakers, an injecting unit for injecting a transient test signal through a first coupling means into a first terminal of the at least one circuit breaker;
- for each one of the at least one circuit breakers, a detecting unit for detecting a resulting transient test signal through a second coupling means at a second terminal of the at least one circuit breaker;
- for each one of the at least one circuit breakers, a monitoring system configured to:
   o detect, during an operation of the circuit breaker, an instant of physical contact of the contacts of the contact pair wherein the contact instant is detected by a change of the amplitude level and/or phase value and/or noise level of the received test signal, when setting the at least one circuit breaker to close or to open, and
   o determine a condition of the at least one circuit breaker depending on a time delay defined by the instant of contact and by a further instant,
      wherein the further instant corresponds to an instant of an additional change of the amplitude level and/or phase value and/or noise level of the received test signal during the operation of the at least one circuit breaker.

According to a further aspect a system is provided, comprising:
- a circuit breaker arrangement with a plurality of circuit breakers, each of which is provided with the above monitoring system;
- a master unit for collecting the determined conditions of the plurality of circuit breakers and for evaluating the condition of the circuit breaker arrangement by comparing the collected conditions of the plurality of circuit breakers.

Furthermore, the injecting units of each of the monitoring systems may be configured to inject the test signal with different frequencies.

A triggering unit may be provided to signal an operation start time to the control units of each of the monitoring systems.

### Brief description of the drawings

Embodiments of the present invention are described in more detail in the following description in conjunction with the appended drawings in which:
- Figure 1: schematically shows a system for monitoring a condition of a circuit breaker;
- Figure 2: schematically shows a circuit breaker;
- Figure 3: shows a more detailed view of the monitoring system for determining a condition of the circuit breaker;
- Figure 4: shows a schematic signal-time diagram for illustrating the characteristics of an amplitude level and a phase value during an opening operation of a circuit breaker; and
- Figure 5: shows a system for monitoring multiple high-voltage circuit breakers in a three-phase power distribution system.

### Description of embodiments

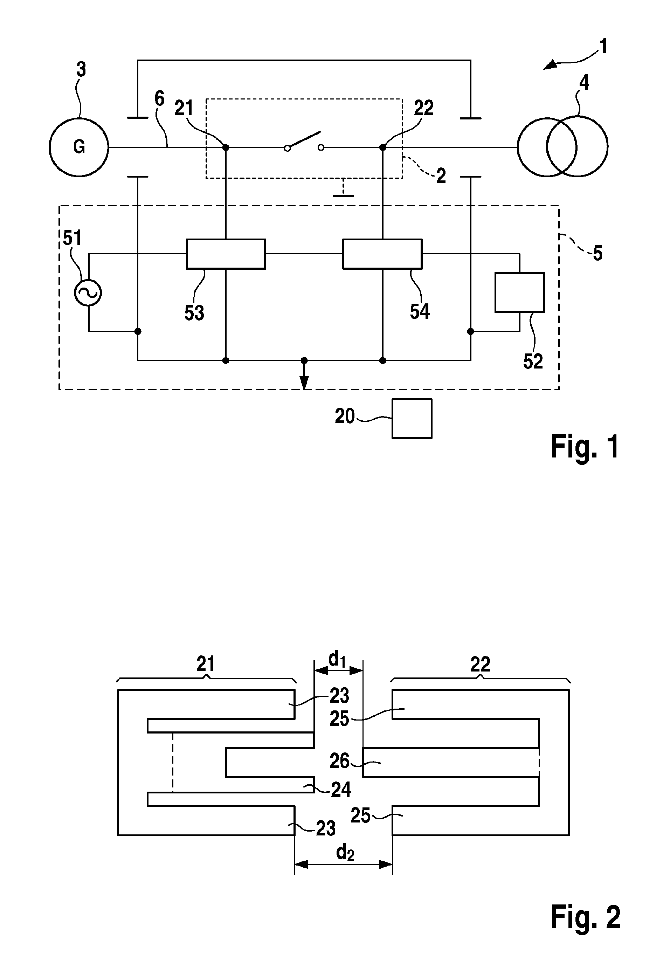

Figure 1 schematically shows a high-voltage system 1 having a generator circuit breaker 2 which couples a high-voltage supply 3, provided by e. g. a generator or a similar source, to an electrical energy sink 4 such as a transformer, a load, an energy supply grid or the like, via a main duct 6. The circuit breaker 2 is represented here with an optional surrounding metallic enclosure connected to ground. Furthermore, a monitoring system 5 for monitoring an ablation level of the circuit breaker 2 is provided.

A cross-section of a circuit breaker 2 interrupting chamber is schematically illustrated in Figure 2. A first terminal 21 of the circuit breaker 2 is provided with a first main contact region 23 and a first arcing contact region 24. A second terminal 22 of the circuit breaker 2 is provided with a second main contact region 25 and a second arcing contact region 26. The circuit breaker 2 of Figure 2 is depicted in an open condition. In the open condition, the first and second arcing contact regions 24, 26 are distanced from each other by a first distance d₁ and the first and second main contact regions 23, 25 are distanced from each other by a second distance d₂.

The first and second arcing contact regions 24, 26 are formed as mating parts, e. g. the first arcing contact region 24 has a U-shaped or cup-shaped contact structure, often called tulip, and the second arcing contact region 26 has a pin-like contact structure, often called a pin, that can be moved between the legs of the U-shaped (or walls of the cup-shaped) contact structure of the first arcing contact region 24. Different mating structures of the contacts can be provided as well.

During a closing operation of the circuit breaker 2, the contact regions of the first and second contacts 21, 22 are moved toward each other. Consequently, the first and second arcing contact regions 24, 26 and the first and second main contact regions 23, 25 are moved toward each other. Due to the shorter first distance d₁, the first and second arcing contact regions 24, 26 contact each other before the first and second main contact regions 23, 25 in a closing operation of the circuit breaker 2.

In a contacting (closed) condition, the first and second arcing contact regions 24, 26 are exhibiting higher impedance than that of the first and second main contact regions 23, 25 in a contacting condition. The first and second arcing contact regions 24, 26 are configured to have a higher resistance against ablation caused by arcing and further allow a controlled ablation of the arcing contact regions 24, 26 in case of an interruption of high-current (and feeding of high-voltage difference). The main task of the arcing contact regions 24, 26 is to support electric arcs and thus to protect the main contact regions 23, 25 from being damaged by arcing.

The ablation of the arcing contact regions 24, 26 leads to a reduction of their length or a hollowing out of the ablation contact system. In other words, the distance between the arcing contact regions 24, 26 due to ablation is increased. Furthermore, the shorter the length of the first and second arcing contact regions 24, 26 is, the higher is the risk of creating an arc between the first and second main contact regions 23, 25 during an opening operation, which may lead to the destruction of the circuit breaker 2.

The monitoring system 5 comprises an injection unit 51 for injecting a transient, e.g. a periodic, test signal into a first terminal 21 of the circuit breaker 2 and a detection unit 52 coupled to a second terminal 22 of the circuit breaker 2 for detecting the test signal after propagation through the circuit breaker 2.

The monitoring systems 5 is provided to monitor the condition of the first and second arcing contact regions 24, 26, so that a state can be signalled to indicate if replacement of the first and second arcing contact regions 24, 26 is required in order to avoid permanent damage.

To inject the periodic test signal into the main duct 6 at the first terminal 21 of the circuit breaker 2, a first coupling means 53 is provided. The first coupling means 53 may be connected directly to the first terminal 21. To receive the test signal at the second terminal 22 of the circuit breaker 2, a second coupling means 54 is provided. The second coupling means 54 may be connected directly to the second terminal 22. The first and second coupling means 53, 54 may be as well switched over.

The first and second coupling means 53, 54 decouple/protect the injection unit 51 and the detection unit 52 from the high-voltage regime of the main duct 6 by providing galvanic insulation while allowing the test signal to propagate. Thus, the normal operation of the circuit breaker 2 does not need to be interrupted to perform a contact ablation measurement/monitoring. Therefore, the overlap time measurement can be carried out during normal operation of the circuit breaker 2.

The test signal return path may be through the breaker enclosure. It may also be provided that the test signal return path does not include the breaker enclosure.

A control unit 20 is provided which is configured to monit53or the condition of the circuit breaker 2. Furthermore, the control unit 20 may be configured to activate or deactivate the generation of the test signal in the injection unit 51. For instance, the generation of the test signal in the injection unit 51 can be deactivated, e.g. when the circuit breaker 2 is not operated.

One way of monitoring the ablation condition of the first and second arcing contact regions 24, 26 is to measure the time interval between the connection or disconnection of the first and second arcing contact regions 24, 26 and of the first and second main contact regions 23, 25 during a switching operation. Assuming constant or nearly constant displacement velocities of the contact regions of the circuit breaker 2, the contacting timings are directly linked to the first and second distances d₁, d₂. The critical parameter to be monitored is the change over time of the time interval between the closure of the arcing contact pair and the closure of the main contact pair.

An alternative or additional option to monitor the ablation condition of the first and second arcing contact regions 24, 26 is to measure the arcing time during an opening operation of the circuit breaker 2 or the pre-arcing time during a closing operation of the circuit breaker 2. The arcing time can be measured by determining the time between an opening of the arcing contact regions 24, 26 and the extinguishing of the arc. The pre-arcing time can be measured by determining the time of generation of an arc and the closing of the arcing contact regions 24, 26. The points of time may be monitored by determining variations in amplitude level, phase value and noise level of a test signal injected through a first terminal 21 of the circuit breaker 2 and tapped at a second terminal 22 of the circuit breaker 2.

Therefore, the injecting unit 51 is configured to inject a periodic test signal at a frequency much higher than the frequency of the voltage on the main duct 6. Frequencies may be between 1 kHz and 100MHz. The periodic test signal is injected into the first terminal 21 of the circuit breaker 2. At the second terminal 22 characteristics of the test signal are measured as long as the test signal appears at the second terminal 22.

In the following, methods for determining the arcing time and pre-arcing time during operation of the circuit breaker 2 are described in more detail. The arcing time corresponds to the time elapsed during opening of the circuit breaker 2 from the instant the arcing contact is physically opened to the instant a generated arc extinguishes at the next current zero. The pre-arcing time corresponds to the time elapsed during a closing operation of the circuit breaker 2 and is determined from the instant an arc appears to the instant the arcing contact is physically closed.

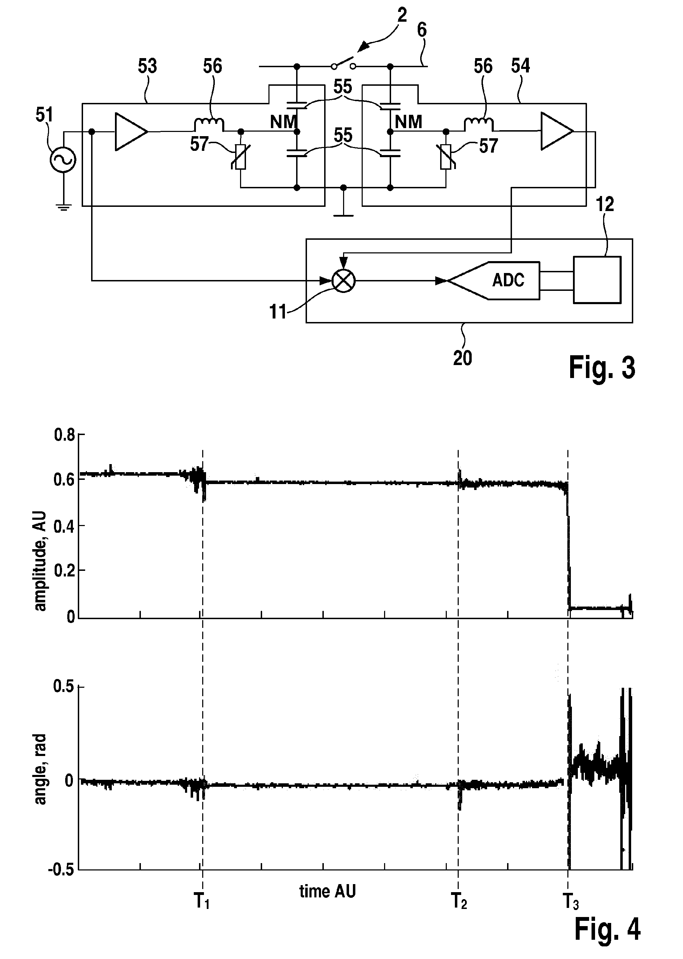

In the more detailed view of figure 3, the coupling means 53, 54 are shown in more detail. The coupling means 53, 54 each may be formed with a capacitive voltage divider. The capacitive voltage dividers each comprise a series connection of two capacitances 55 forming a middle node NM for injection of the test signal or for monitoring a resulting signal, respectively. A top capacitor (connected to the main duct 3) of the capacitive voltage divider allows for maintaining electrical insulation of the main duct 3 or a corresponding terminal 21, 22 of the circuit breaker 2, respectively, while a bottom capacitor (connected to the earth/ground) of the capacitive voltage divider is for voltage division and may be a parasitic capacitance and may therefore be provided as a discrete capacitor or may be omitted.

The middle node NM of each capacitive voltage divider is connected with a respective peaking inductors 56 in order to obtain a series resonant circuit and provide a low-impedance path for the test signal to be applied on the first terminal 21 of the circuit breaker 2 and to reach the control unit 20 over a narrow frequency range, respectively. Varistor 57 may be connected between the middle node NM and the ground potential GND to protect the monitoring system 5 from overvoltage.

The control unit can be integrated on the receiver side or separate therefrom. The injection unit 51 supplying the test signal is coupled with the control unit 20 and the test signal received in the coupling means 54 is also supplied to the control unit 20. The control unit 20 may include a mixer 11 to mix the injected test signal and the received test signal and provide the result to a logic portion 12 which does the monitoring.

In Figure 4 the amplitude and phase characteristics of a received test signal for an opening operation of the circuit breaker 2 is shown. Instants can be determined by a change of characteristics of the received test signal. When the main contact regions 23, 25 open a slight change of the amplitude and phase characteristics can be detected at instant T1. Furthermore, during an opening operation, an arc can be incepted.

An instant T2 (also referred to as the instant of contact) when the arcing contact regions 24, 26 open can be detected by a significant change of the amplitude level and the phase value of the test signal. So the instances T1, T2 of the main and arcing contact separation are clearly visible on the amplitude level and phase value characteristics of the received signal. Additionally, the disconnection of the arcing contact regions 24, 26 is accompanied by an important change in the phase of the received test signal.

The duration between the instants T1 and T2 corresponds to an overlap time. The duration of the overlap time can indicate the ablation condition of the arcing contact regions 24, 26.

The instant T2 of arcing contact separation results in a measurable signal change both on the amplitude and phase waveforms. Hence, the instant T2 can be regarded as the instant of arc ignition. The arc impedance is low enough to produce no measurable change in amplitude or phase on the test signal while the arc exists. However, the amount of noise on both amplitude and phase signals significantly increases to a detectable level during the arcing phase. The extinguishing of the arc at an instant T3 is accompanied by significant amplitude and phase changes. At this instant, the power current stops flowing. Therefore, the instant of arc extinction can be detected by detecting a change of the amplitude and/or the phase of the received test signal.

The arcing time is indicated as the time difference between the instants T2 and T3.

Basically on the occurrence of an arc, the time instant of contact as the point of time at the opening of the arcing contact regions 24, 26 may be difficult to detect since even after separation of the acing contact regions 24, 26 the arc keeps on conducting/transmitting the test signal therethrough. Options to detect the duration of the arc by monitoring the test signal may be as follows:
1. Analysing the noise content of the received test signal since the noise increases at the beginning of the arc period, where the noise level is kept as long as the arc exists.
2. Analysing transient peaks which occur at the instant at or just before the inception of the arc, since the voltage difference across the separated contacts increases abruptly due the inductive nature of the electrical system. A transient peak in the received test signal is thus created at the time instant of this abrupt changes in voltage, which actually corresponds to the opening of the arcing contact.
3. Analysing the strength of the received test signal. The test signal strength may slightly but suddenly decrease at the inception of the arc and may gradually decrease during the arc period.

For the closing of the circuit breaker 2, the pre-arcing time can be detected similarly by measuring the time elapsed between an instant of occurrence of the pre-arc where the amplitude and phase significantly changes or starts having transient changes (peaks), respectively. During the existence of the pre-arc a substantially increased amount of noise in the amplitude and phase signal exists. The end of the pre-arcing time period can be detected by the time when a noise level of the amplitude and phase characteristics decreases. The pre-arcing time period therefore can be measured between the instant where a significant change of amplitude level and/or phase value occurs and an instant where the noise level decreases due to the physically closing of the arcing contacts.

The possibly transient change of the amplitude level and/or the phase value and/or the noise level can be detected by detecting an indication of a corresponding value at a first point of time and detecting an indication of a corresponding value at a second point of time defining a time window. The indication detected at the different points of time are compared and a significant change can be determined in case the difference between the detected indications exceeds a predetermined threshold value.

The overlap time as well as the arcing time or the pre-arcing time can be related to the ablation of the arcing contact and therefore to a general condition of the circuit breaker 2.

Generally, as the arcing contact regions 24, 26 are exposed to ablation during each switching cycle, the monitoring of the arcing and pre-arcing times during switching operations can indicate the remaining lifetime of the circuit breaker 2. However, to further derive the exact degradation of the arcing contact regions 24, 26 induced by the (pre-)arcing the switched current may be further considered. The switched current is a result of the current differences of the current before instant T1 and after instant T3.

Hence, the pre-arcing/arcing time and the amount of switched/interrupted current indicate the degradation of the circuit breaker 2 for the closing/opening operations. Integrating or summing an indication about the degradations, respectively, allows to track the health of the circuit breaker 2.

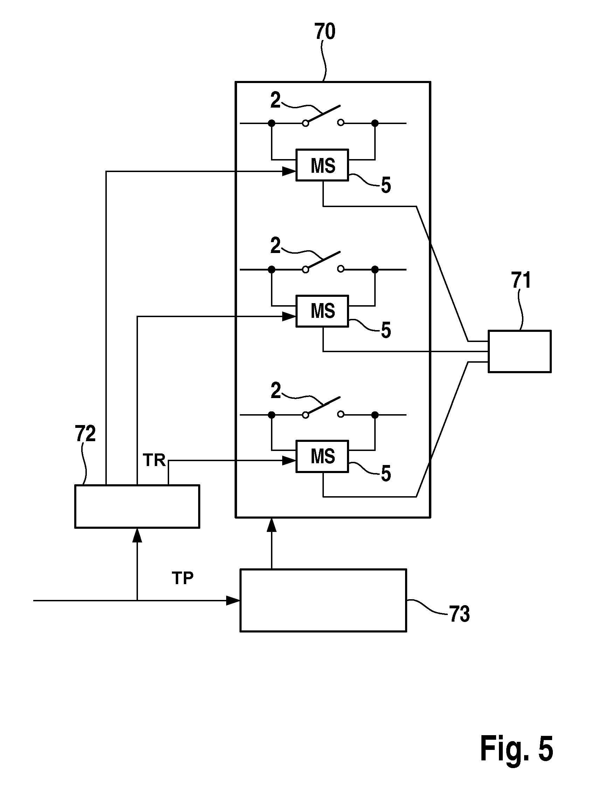

In Figure 5, a circuit breaker arrangement 70 for a three-phase system is shown provided with a monitoring system 5 for each of three single circuit breakers 2 forming a circuit breaker arrangement. Each of the circuit breakers 2 can be triggered by a trip signal TP provided to an operating mechanism 73 which is configured to mechanically actuate the opening or closing of the circuit breakers 2. Each of the monitoring systems 5 is configured as described above, where overlap and arcing times (pre-arcing times) can thereby be detected. The measurement results of the monitoring systems 5 can be sent and stored in a master unit 71. The monitoring systems 5 can each be triggered simultaneously by a trigger signal TR generated from the trip signal TP.

To minimize the cross-talk between the phases of the multi-phase circuit, the frequencies of the test signals to be injected of the individual monitoring systems 5 can be selected to be different from each other by using for instance peaking inductors 56 with different values so that the resonant frequencies of the L-C resonators on each phase are different.

The master unit 71 is configured to collect the conditions of the plurality of circuit breakers 2 determined by the monitoring systems 5 and for evaluating the condition of the circuit breaker arrangement 70 by comparing the collected conditions of the plurality circuit breakers 2. Particularly, a condition of the circuit breaker arrangement 70 is determined based on the difference between the conditions of the single circuit breakers 2 determining e.g. an ablation level of a contact pair of a respective circuit breaker 2.

The trip signal can either be sent through to the individual monitoring systems 5 or firstly fed into an optional triggering unit 72 that generates the trigger signal for each of the monitoring systems 5. So the time delay introduced by the triggering electronics in the cabling to the monitoring systems 5 can be reduced. This allows to simultaneously obtain the indication about the conditions from all of the circuit breakers 2.

## Claims

1. Method for measuring a condition of at least one circuit breaker (2) in a high voltage system (1), wherein the at least one circuit breaker (2) having a contact pair (24, 26); comprising the steps of:
- injecting a transient test signal through a first coupling means (53) into a first terminal (21) of each of the at least one circuit breaker (2);
- detecting a resulting transient test signal through a second coupling means (54) at a second terminal (22) of each of the at least one circuit breaker (2);
- detecting, during an operation of the circuit breaker (2), the instant of physical contact of the contacts of the contact pair (24, 26), wherein the instant of contact is detected by a change of the amplitude level and/or phase value and/or noise level of the received test signal, when setting the at least one circuit breaker (2) to close or to open, and
- determining the condition of the at least one circuit breaker (2) depending on a time delay defined by the instant of contact and by a further instant,
wherein the further instant corresponds to an instant of an additional change of the amplitude level and/or phase value and/or noise level of the received test signal during the operation of the at least one circuit breaker (2).

2. Method according to claim 1, wherein the time delay includes an arcing time which is determined during an opening operation of the at least one circuit breaker (2) as the time difference between the instant of contact and the further instant of extinction of an arc which is detected by a change of the amplitude level and/or phase value on the received test signal.

3. Method according to claim 1 or 2, wherein the time delay includes a pre-arcing time which is determined during a closing operation of the at least one circuit breaker (2) as the time difference between the further instant of generation of an arc which is detected by a change of the amplitude level and/or phase value of the received test signal and the instant of contact.

4. Method according to claim 2 or 3, wherein a switched current is detected, wherein the switched current indicates a current flowing at a fully closed state of the circuit breaker (2), wherein the condition of the at least one circuit breaker (2) is determined depending on the pre-arcing/arcing time defined by the instant of contact and the detected switched current.

5. Method according to any of the claims 1 to 4, wherein the at least one circuit breaker (2) having an arcing contact pair (24, 26) as the contact pair and a main contact pair (23, 25) providing different impedances, wherein the circuit breaker (2) is further configured so that during opening operations the arcing contact pair opens after the main contact pair (23, 25) opens and during closing operations the arcing contact pair (24, 26) closes before the main contact pair (23, 25) closes, wherein an overlap time is determined during an operation of the at least one circuit breaker (2) based on the time delay elapsed between the instant of contact and the further instant which is detected by a change of the amplitude level and/or phase value due to an impedance change.

6. Method according to any of the claims 1 to 5, wherein the instant of contact is detected by a change of the noise level of the received test signal.

7. Method according to any of the claims 1 to 6, wherein the remaining lifetime of the at least one circuit breaker (2) is determined based on the determined condition.

8. Method according to any of the claims 1 to 7, wherein multiple circuit breakers (2) are provided, wherein the first time of closing or opening of the arcing contact pair (24, 26) of each of the circuit breakers (2) and a second time of closing or respectively opening of each of the circuit breakers (2) is communicated to a master unit (71), wherein the condition of each of the multiple circuit breakers (2) are determined in the master unit (71).

9. Method according to any of the claims 1 to 8, wherein multiple circuit breakers (2) are provided, wherein at least two of the transient test signals injected into the respective circuit breaker (2) have at least one different frequency.

10. Monitoring system (5) for monitoring a condition of at least one circuit breaker (2) in a high voltage system; comprising:
- for each one of the at least one circuit breakers (2), an injecting unit (51) for injecting a transient test signal through a first coupling means (53) into a first terminal (21) of the at least one circuit breaker (2);
- for each one of the at least one circuit breakers (2), a detecting unit (52) for detecting a resulting transient test signal through a second coupling means (54) at a second terminal (22) of the at least one circuit breaker (2);
- for each one of the at least one circuit breakers (2), a monitoring system configured to:
o detect, during an operation of the circuit breaker (2), the instant of a physical contact of the contacts of the contact pair (24, 26) wherein the instant of contact is detected by a change of the amplitude level and/or phase value and/or noise level of the received test signal, when operating the at least one circuit breaker (2) to close or to open, and
o determine the condition of the at least one circuit breaker (2) depending on a time delay defined by the instant of contact and by a further instant,
wherein the further instant corresponds to an instant of a further additional change of the amplitude level and/or phase value and/or noise level of the received test signal during the operation of the at least one circuit breaker (2).

11. Circuit breaker system comprising
- a circuit breaker arrangement (70) with a plurality of circuit breakers (2), each of which is provided with the monitoring system (5) according to claim 10;
- a master unit (71) for collecting the determined conditions of the plurality of circuit breakers (2) and for evaluating the condition of the circuit breaker arrangement (70) by comparing the collected conditions of the plurality circuit breakers (2).

12. System according to claim 11, wherein a triggering unit (72) is provided to signal an equal operation start time to each of the monitoring systems (5) by providing a trigger signal (TR).

13. System according to claim 11 or 12, wherein the injecting units (51) of each of the monitoring system (5) are configured to inject the test signal with different frequencies.
